# EUROPÄISCHE PATENTSCHRIFT

(11) **EP 4 060 093 B1**
(45) Veröffentlichungstag und Bekanntmachung des Hinweises auf die Patenterteilung: **21.05.2025**
(21) Anmeldenummer: 21163067.8
(22) Anmeldetag: 17.03.2021
(51) Int. Cl.: C25D 5/12, C23C 28/00, C23C 2/04, C23C 24/06, C23C 4/08, C25D 7/00, C25D 7/06

(54) **TRIBOLOGISCH VERBESSERTE OBERFLÄCHEN FÜR ELEKTRISCHE KONTAKTE**
TRIBOLOGICALLY ENHANCED SURFACES FOR ELECTRICAL CONTACTS
SURFACES TRIBOLOGIQUEMENT AMÉLIORÉES POUR CONTACTS ÉLECTRIQUES

(43) Veröffentlichungstag der Anmeldung: 21.09.2022
(73) Patentinhaber: Rosenberger Hochfrequenztechnik GmbH & Co. KG, 83413 Fridolfing (DE)
(72) Erfinder: Wagner, Reinhard, 5201 Seekirchen am Wallersee (AT); Dandl, Christian, 83413 Fridolfing (DE)
(74) Vertreter: Aera A/S

(56) Entgegenhaltungen:
- EP-A1- 3 633 256
- DE-A1- 102018 005 348
- JP-A- 2001 287 079
- RU-C1- 2 364 781
- US-A1- 2021 066 834

## Beschreibung

Die vorliegende Erfindung betrifft ein Verfahren zur Herstellung eines elektrischen Kontakts, einen elektrischen Kontakt sowie die Verwendung eines elektrischen Kontakts für Steckverbindungen.

Elektrische Kontakte weisen Kontaktoberflächen auf, die in der Regel aus einem elektrisch leitfähigen Material, vorzugsweise einem metallischen Leiter bestehen. Elektrische Kontakte bestehen vorzugsweise aus einem starren und einem federnden Ende, das die Kontaktkraft aufbringt, wobei beide Enden meist einen metallischen Überzug aufweisen, der sich vom Basismaterial unterscheidet. Diese Beschichtung kann beispielsweise durch Eintauchen in eine Metallschmelze durch physikalische und/oder chemische Gasphasenabscheidung, oder durch außenstromlose bzw. elektrolytische Beschichtung hergestellt werden. Häufig verwendete Beschichtungswerkstoffe sind Gold, Silber, Palladium, Platin, Rhodium, Ruthenium, Nickel, Zinn, Kupfer, Zink oder Legierungen daraus. Durch die Verwendung solcher Beschichtungen können gewünschte Eigenschaften der elektrischen Kontaktoberfläche, wie beispielsweise eine verbesserte Korrosionsbeständigkeit, ein verbessertes Verschleißverhalten, die Gewährleistung eines stabilen elektrischen Übergangswiderstands, und/oder eine Reduktion des Reibungskoeffizienten erzielt werden.

Um eine weitere Verbesserung des Verschleißverhaltens zu erzielen, werden für elektrische Kontaktoberflächen häufig sogenannte Kontaktschmiermittel verwendet. Aus Chudnovsky (2005; Lubrication of electrical contacts; In Proceedings of the Fifty-First IEEE Holm Conference on Electrical Contacts; 2005; pp. 107-114; IEEE) sind eine Reihe entsprechender Kontaktschmiermittel bekannt, wobei im Einzelnen zwischen Mineralölen, Fetten, synthetisch hergestellten Schmiermitteln basierend auf synthetisch hergestellten Verbindungen, wie Polyphenylether (PPE) und perfluorierten Polyether (PFPE), sowie Festschmierstoffen wie Graphit, Molybdändisulfid, Polytetrafluorethylen (PTFE) und Dispersionen aus Festschmierstoffen und den genannten flüssigen/pastösen Schmierstoffen, unterschieden wird.

Es hat sich jedoch gezeigt, dass die bloße Schmierung von elektrischen Kontaktoberflächen mittels der genannten Festschmierstoffe zu einer Verschlechterung der elektrischen Leitfähigkeit führt, die wiederum in einem hohen Anstieg des elektrischen Übergangswiderstands resultiert, unerwünscht ist, so dass weiterhin Bedarf nach verbesserten elektrischen Kontaktoberflächen bzw. elektrischen Kontakten besteht.

Aus der DE2543082A1 ist ein Silber-Graphit Dispersionsüberzug bekannt, wobei Graphit als Festschmierstoff mittels galvanischer Dispersionsabscheidung in eine Metallmatrix eingelagert wird. Nachteilig ist bei diesem Verfahren die mangelnde Flexibilität durch die Beschränkung auf bestimmte Elektrolytzusammensetzungen sowie die mittels galvanischer Dispersionsabscheidung abscheidbaren Metalle.

Aus Berman et al. (Berman, D.; Erdemir, A.; Sumant, A. V.; 2014; Graphene as a protective coating and superior lubricant for electrical contacts; Appl. Phys. Lett. 105, 231907 (2014); DOI: 10.1063/1.4903933) ist eine weitere Beschichtung für elektrische Kontakte bekannt. Die Beschichtung umfasst Graphen, wodurch eine Verbesserung der tribologischen Eigenschaften durch die Reduktion des Reibkoeffizienten sowie eine Reduktion des Verschleißes erzielt wird. Zur Herstellung der Beschichtung werden Graphenpartikel auf ein Goldsubstrat aufgebracht, indem eine Graphen-Ethanol-Suspension mit einem Graphengehalt von 1 mg/mL auf die Goldoberfläche getropft und das Lösungsmittel anschließend verdampft wird. Die resultierende Oberfläche weist einen Bedeckungsgrad von etwa 50 % auf. Der resultierende Kontaktwiderstand dieser Beschichtungen ist jedoch mit einem Wert von 100 Ohm für zahlreiche Anwendungen als elektrische Kontaktoberflächen zu hoch. Zudem ist die Herstellung dieser Beschichtung sehr aufwendig und kostenintensiv.

Aus der US 3,644,133 A ist ein Verfahren zur Herstellung von Festschmierstoffbasierenden Beschichtungen bekannt. Der hierin eingesetzte Festschmierstoff weist eine schichtartige Kristallstruktur auf. Des Weiteren ist aus der US 5,407,590 A sowie aus der WO 96/20083 A1 jeweils ein Schmierstoff bekannt, der aus Übergangsmetalldichalkogeniden und Polymeren gebildet wird.

EP 3633256 A1 betrifft eine Gewindeverbindung mit ausgezeichneter Fehlausrichtungsbeständigkeit und hoher Drehmomentfestigkeit sowie ein Verfahren zur Herstellung der Gewindeverbindung.

US 2021/066834 A1 betrifft einen Kontakt mit geringer Einsteckkraft umfassend eine leitende Basisschicht, die sich zu einem Steckende erstreckt. Auf der leitenden Basisschicht ist eine Silberschicht vorgesehen und eine Silbersulfidoberflächenschicht bildet ein festes Schmiermittel direkt auf der Silberschicht.

RU 2364781 C1 betrifft Gewindeverbindungen für Stahlrohre. Bei der Gewindeverbindung wird die erste aufgebrachte Schicht aus einer Sn-Bi-Legierung oder einer Sn-Bi-Cu-Legierung auf der Kontaktfläche von mindestens einem Nippel und einer Kupplung gebildet.

Die JP 2001 287079 A betrifft einen Stahldraht für das Lichtbogenschweißen, der sich dadurch auszeichnet, dass er an seiner Oberfläche mit einem Schmiermittel versehen ist.

Die DE 10 2018 005348 A1 betrifft einen Silberelektrolyt zur Abscheidung von Silberschichten auf Substraten, wobei der Elektrolyt und die abgeschiedene Schicht mindestens eine Feststoffkomponente aufweisen.

Vor diesem Hintergrund ist es die Aufgabe der vorliegenden Erfindung ein Verfahren zur Herstellung eines elektrischen Kontakts und elektrischen Kontakt bereitzustellen, der einen vorteilhaften Reibkoeffizienten, eine hohe Verschleißbeständigkeit sowie einen guten Kontaktwiderstand aufweist. Das Verfahren soll zudem zeitsparend und kostengünstig sein.

### Beschreibung der Erfindung

Erfindungsgemäß wird die Aufgabe gelöst durch ein Verfahren zur Herstellung eines elektrischen Kontakts gemäß Patentanspruch 1, einen elektrischen Kontakt gemäß Patentanspruch 5, der Verwendung eines elektrischen Kontakts gemäß Patentanspruch 15.

In einem ersten Aspekt betrifft die Erfindung ein Verfahren zur Herstellung eines elektrischen Steckkontakts (1), umfassend, bevorzugt bestehend aus, die Schritte
a) Bereitstellen eines Substrats (2), wobei das Substrat eine metallische und/oder metallisierte Oberfläche aufweist, und
b) Aufbringen einer Gleitschicht auf die metallische und/oder metallisierte Oberfläche des Substrats (2), wobei die Gleitschicht (6) eine Schichtdicke von 0,01 µm bis 4 µm aufweist,
   wobei die Gleitschicht (6) durch mechanisches Einreiben, Aufpolieren und/oder Schwabbeln eines Festschmierstoffs aufgebracht wird; oder
   wobei die Gleitschicht (6) durch Sputtern eines Festschmierstoffs aufgebracht wird; oder
   wobei die Gleitschicht (6) durch Aufsprühen eines Festschmierstoffs unter Verwendung eines Trägergases, aufgebracht wird; oder
   wobei die Gleitschicht (6) durch Aufbringen eines Festschmierstoffs mittels eines Trommelwäschers, vorzugsweise in Anwesenheit von Zusatzmitteln und/oder Füllkörpern, aufgebracht wird.

Überraschenderweise hat sich gezeigt, dass durch mechanisches Aufbringen, Sputtern, Aufsprühen oder Aufbringen mittels Trommelwäscher einer Gleitschicht auf ein Substrat, welches eine metallische und/oder metallisierte Oberfläche aufweist, die tribologischen Eigenschaften eines elektrischen Kontakts signifikant verbessert werden können, ohne dabei die elektrischen Eigenschaften, insbesondere den Kontaktwiderstand, wesentlich negativ zu beeinflussen. Die im Vergleich zum Stand der Technik verbesserten tribologischen Eigenschaften führen gleichzeitig zu einer Reduzierung des Verschleißes, so dass insbesondere die erfindungsgemäßen elektrischen Kontakte, sofern sie für Steckkontakte verwendet werden, höheren Steckzyklen standhalten bei gleichzeitig stabilen Kontaktwiderstandswerten.

Weiterhin kann in Abhängigkeit des eingesetzten Festschmierstoffs das Auftrageverfahren besonders einfach durchgeführt werden, so dass beispielsweise Hilfsmittel, wie Binder und ähnliche Materialien, nicht erforderlich sind, was sich besonders vorteilhaft auf die Kosten des erfindungsgemäßen Verfahrens auswirkt.

Des Weiteren hat sich überraschenderweise gezeigt, dass die erfindungsgemäßen elektrischen Kontakte, neben den bereits erläuterten Vorteilen, eine erhöhte Temperaturbeständigkeit aufweisen, so dass ein Einsatz bei höheren Temperaturen und/oder unter Vakuum dieser und/oder der hieraus hergestellten elektrischen Kontakte ermöglicht wird. Zudem halten die elektrischen Kontakte hohen Kontaktdrücken stand, ohne dabei die positiven tribologischen Eigenschaften zu verlieren.

Weitere vorteilhafte Ausgestaltungen der Erfindung sind in den abhängig formulierten Ansprüchen angegeben. Die in den abhängig formulierten Ansprüchen einzeln aufgeführten Merkmale sind in technologisch sinnvoller Weise miteinander kombinierbar und können weitere Ausgestaltungen der Erfindung definieren. Darüber hinaus werden die in den Ansprüchen angegebenen Merkmale in der Beschreibung näher präzisiert und erläutert, wobei weitere bevorzugte Ausgestaltungen der Erfindung dargestellt werden.

Unter dem Begriff "Festschmierstoff" wird im Sinne der vorliegenden Erfindung ein Schmierstoff verstanden, der in festem Aggregatzustand vorliegt und in diesem verwendet wird.

Unter dem Begriff "mittlere Partikelgröße (d50)" wird im Sinne der vorliegenden Erfindung verstanden, dass 50% der Partikel eines Feststoffbestandteils einen kleineren Durchmesser haben als der angegebene Wert. Der d90-Wert gibt an, dass 90% der Partikel eines Feststoffbestandteils einen kleineren Durchmesser haben als der angegebene Wert.

Unter dem Begriff "metallische Oberfläche" wird im Sinne der vorliegenden Erfindung eine Oberfläche eines metallischen Substrats verstanden. Das Substrat kann hierbei aus einem Reinmetall oder einer Legierung bestehen.

Unter dem Begriff "metallisierte Oberfläche" wird im Sinne der vorliegenden Erfindung eine metallenthaltende Oberfläche verstanden, die direkt auf ein Substrat, insbesondere NichtMetall Substrat, aufgebracht wird. Insbesondere werden die Oberflächen von elektrisch nicht-leitenden Materialien wie Kunststoffen, Glas, Oxiden, Halbleitern oder Keramiken metallisiert. Derartige Oberflächen werden beispielsweise vernickelt, verzinkt, verzinnt, verkupfert, verchromt oder mit anderen Materialien beschichtet, wie mit Aluminium- und Magnesiumlegierungen, Eisen, Stahl, oder technische Legierungen dieser Metalle, oder auch mit Edelmetallen, wie Gold oder Silber oder deren Legierungen. Bevorzugte Legierungen für die Beschichtung von Substratoberflächen sind Kupfer, Zink, Legierungen aus Zink/Eisen, Zink/Mangan, Zink/Cobalt oder Zinn, Legierungen aus Zinn/Kupfer, Zinn/Zink, Zinn/Blei, Zinn/Silber, Zinn/Bismut. Verschiedene Verfahren zur Metallisierung sind bspw. aus der DE 102016222943 B bekannt.

Unter dem Begriff "Zwischenschicht" wird im Sinne der vorliegenden Erfindung eine Schicht bezeichnet, die auf einem Substrat angeordnet ist, wobei zwischen Substrat und Zwischenschicht eine weitere Metallschicht oder mehrere weitere Metallschichten angeordnet sein können. Auf die Zwischenschicht wird, sofern diese vorhanden ist, die Gleitschicht aufgebracht.

Zur Herstellung der erfindungsgemäßen elektrischen Kontakte können alle üblichen Substrate, insbesondere metallische Substrate, verwendet werden.

Gemäß einer bevorzugten Ausführungsform ist das Substrat ein metallisches Substrat. Bevorzugt ist das metallische Substrat aus Kupfer, Eisen, Zink, Zinn, Aluminium und/oder Legierungen hiervon gebildet. Legierungen sind vorzugsweise Bronze oder Messing. Bevorzugter ist das metallische Substrat aus Kupfer, Eisen und/oder aus einer Legierung hiervon gebildet.

Gemäß einer anderen bevorzugten Ausführungsform ist das Substrat ein nichtmetallisches Substrat. Bevorzugt ist das nicht-metallische Substrat aus Kunststoff, Glas, Oxiden, Halbleitern und/oder Keramiken gebildet, bevorzugter ist das nicht-metallische Substrat aus Kunststoff oder Keramik gebildet. Vorzugsweise weist das nicht-metallische Substrat eine metallisierte Oberfläche auf.

In einer bevorzugten Ausführungsform weist das Substrat eine Zwischenschicht auf. Die Gleitschicht wird in dieser Ausführungsform auf die Zwischenschicht aufgebracht.

In einer weiteren bevorzugten Ausführungsform ist die Zwischenschicht aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet.

Vorzugsweise ist die Zwischenschicht eine Zinn- oder Silberschicht.

Vorzugsweise wird die Zwischenschicht galvanotechnisch, durch Eintauchen in eine metallische Schmelze, thermische Spritzverfahren, Verfahren zur physikalischen Gasphasenabscheidung, durch Feuerverzinnung, oder Verfahren zur chemischen Gasphasenabscheidung aufgebracht. Zu den thermischen Spritzverfahren zählen Flammspritzen, Laserspritzen, Plasmaspritzen und weitere verwandte Verfahren. Bevorzugter wird die Zwischenschicht galvanotechnisch oder durch Feuerverzinnung aufgebracht. Weiterhin bevorzugt wird die Zwischenschicht mittels außenstromloser Verfahren aufgebracht. Außenstromlose Verfahren sind aus dem Stand der Technik bekannt.

In einer weiteren bevorzugten Ausführungsform weist das Substrat eine Zwischenschicht und zumindest eine weitere Metallschicht auf, wobei die zumindest eine weitere Metallschicht zwischen dem Substrat und der Zwischenschicht angeordnet ist, wobei die zumindest eine weitere Metallschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist. Die Gleitschicht wird auf die Zwischenschicht aufgebracht.

Gemäß einer weiteren bevorzugten Ausführungsform weist das Substrat eine Zwischenschicht und zumindest zwei weitere Metallschichten auf, wobei die zumindest zwei weiteren Metallschichten zwischen dem Substrat und der Zwischenschicht angeordnet sind, wobei die zumindest zwei weiteren Metallschichten vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet sind. Die Gleitschicht wird auf die Zwischenschicht aufgebracht.

Legierungen können beispielsweise Cu-Sn-Zn-Legierungen, vorzugweise Weißbronze, sein.

Die Zwischenschicht und die Metallschichten können neben den vorgenannten Metallen auch bis zu einem Anteil von 0,001 bis 15 Gew.% und bevorzugt von 0,01 bis 10 Gew.% bezogen auf die Gesamtmasse der jeweiligen Schicht weitere anorganische Bestandteile wie Phosphor, Bor, Antimon, Tellur, Cobalt, Indium, Eisen, Wolfram oder Mischungen hieraus enthalten. Ebenso können auch Anteile an Hartmetallen wie Wolfram zugesetzt sein.

Gemäß einer bevorzugten Ausführungsform enthalten die Zwischenschicht und die Metallschichten neben den vorgenannten Metallen 0,01 bis 1 Gew.% und bevorzugt 0,05 bis 0,5 Gew.% bezogen auf die Gesamtmasse der jeweiligen Schicht weitere anorganische Bestandteile wie Phosphor, Bor, Antimon, Tellur, Cobalt, Indium, Eisen, Wolfram oder Mischungen hieraus.

Gemäß einer bevorzugten Ausführungsform umfasst, vorzugsweise besteht aus, Schritt a) die folgenden Schritte: Bereitstellen eines Substrats und Aufbringen einer Zwischenschicht.

Gemäß einer weiteren bevorzugten Ausführungsform umfasst, vorzugsweise besteht aus, Schritt a) die folgenden Schritte: Bereitstellen eines Substrats, Aufbringen zumindest einer weiteren Metallschicht, vorzugsweise einer weiteren ersten Metallschicht und einer weiteren zweiten Metallschicht, und anschließend Aufbringen einer Zwischenschicht.

Gemäß einer weiteren bevorzugten Ausführungsform umfasst, vorzugsweise besteht aus, Schritt a) die folgenden Schritte: Bereitstellen eines Substrats, Aufbringen zumindest drei weitere Metallschichten und anschließend Aufbringen einer Zwischenschicht.

Die Metallschichten können galvanotechnisch, durch Eintauchen in eine metallische Schmelze, thermische Spritzverfahren, Verfahren zur physikalischen Gasphasenabscheidung, durch Feuerverzinnung oder Verfahren zur chemischen Gasphasenabscheidung aufgebracht werden. Zu den thermischen Spritzverfahren zählen Flammspritzen, Laserspritzen, Plasmaspritzen und weitere verwandte Verfahren. Bevorzugter wird die Zwischenschicht galvanotechnisch oder durch Feuerverzinnung aufgebracht. Weiterhin bevorzugt können die Metallschichten mittels außenstromloser Verfahren aufgebracht werden.

In einer bevorzugten Ausführungsform ist der Festschmierstoff ausgewählt aus der Gruppe bestehend aus Sulfiden, Seleniden und/oder Telluriden. Weiter bevorzugt ist der Festschmierstoff ausgewählt aus der Gruppe bestehend aus WS₂, MoS₂, NbS₂, NbSe₂, TaS₂, MoTe₂, MoSe₂, WTe₂, WSe₂, HfS₂, SnS₂, Bi₂S₃, Sb₂S₃ und/oder Mischungen hiervon.

In einer weiteren bevorzugten Ausführungsform ist der Festschmierstoff ausgewählt aus der Gruppe bestehend aus Graphit, Graphitoxid, Graphitfluorid, Phthalocyanin, organischen Polymeren, insbesondere Polytetrafluorethylen (PTFE) und/oder hiervon abgeleitete Metallkomplexen.

Das Beschichten mit der Gleitschicht kann auf unterschiedliche Weisen erfolgen. So kann die Gleitschicht mechanisch durch Einreiben, Aufpolieren und/oder Schwabbeln auf die Zwischenschicht aufgetragen werden.

Die Gleitschicht kann auch auf die Zwischenschicht aufgesputtert werden.

Weiterhin kann der partikuläre Festschmierstoff durch ein gasförmiges Trägermedium, beispielsweise Luft, auf die Zwischenschicht aufgesprüht werden. Die Haftung kann hierbei über die Sprühparameter, wie durch den Druck, gezielt eingestellt werden.

Weiterhin kann die Gleitschicht auf die Zwischenschicht gegebenenfalls in Anwesenheit von Zusatzmitteln und/oder Füllkörpern, über einen Trommelwäscher oder unter Einsatz von vibrierenden Gefäßen aufgetragen werden.

In einem zweiten Aspekt betrifft die Erfindung einen elektrischen Kontakt, der nach dem Verfahren gemäß einem der Ansprüche 1 bis 4 erhältlich ist, aufweisend ein Substrat (2), wobei das Substrat (2) eine metallische und/oder metallisierte Oberfläche aufweist, und zumindest eine auf der metallischen und/oder metallisierten Oberfläche des Substrats (2) angeordnete Gleitschicht (6), die aus einem Festschmierstoff besteht, wobei der elektrische Kontakt ein elektrischer Steckkontakt ist, und wobei die Gleitschicht (6) eine Schichtdicke von 0,01 µm bis 4 µm aufweist, wobei der Festschmierstoff ausgewählt ist aus der Gruppe bestehend aus Sulfiden, Seleniden und/oder Telluriden.

Erfindungsgemäß ist der elektrische Kontakt ein elektrischer Steckkontakt.

In einer bevorzugten Ausführungsform weist das Substrat eine auf der metallischen und/oder metallisierten Oberfläche des Substrats angeordnete Zwischenschicht auf. Die Zwischenschicht ist vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet. Die Gleitschicht ist auf der Zwischenschicht angeordnet.

In einer weiteren bevorzugten Ausführungsform weist das Substrat eine auf der metallischen und/oder metallisierten Oberfläche des Substrats angeordnete zumindest eine weitere Metallschicht auf. Die zumindest eine weitere Metallschicht ist vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet. Auf der zumindest einen weiteren Metallschicht ist eine Zwischenschicht angeordnet, wobei die Zwischenschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist. Die Gleitschicht ist auf der Zwischenschicht angeordnet.

In einer weiteren bevorzugten Ausführungsform weist das Substrat eine auf der metallischen und/oder metallisierten Oberfläche des Substrats angeordnete zumindest eine erste weitere Metallschicht auf, wobei die zumindest eine erste weitere Metallschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, wobei auf der ersten weiteren Metallschicht eine zweite weitere Metallschicht angeordnet ist, wobei die zumindest eine zweite weitere Metallschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, und wobei auf der zumindest zweiten weiteren Metallschicht eine Zwischenschicht angeordnet ist, wobei die Zwischenschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist. Die Gleitschicht ist auf der Zwischenschicht angeordnet.

Gemäß einer bevorzugten Ausführungsform ist das Substrat ein metallisches Substrat. Bevorzugt ist das metallische Substrat aus Kupfer, Eisen, Zink, Zinn, Aluminium und/oder Legierungen hiervon gebildet. Legierungen sind vorzugsweise Bronze oder Messing. Bevorzugter ist das metallische Substrat aus Kupfer, Eisen und/oder einer Legierung hiervon gebildet.

Gemäß einer weiteren bevorzugten Ausführungsform ist das Substrat ein nichtmetallisches Substrat. Bevorzugt ist das nicht-metallische Substrat aus Kunststoff, Glas, Oxiden, Halbleiter und/oder Keramik gebildet, bevorzugter ist das Substrat aus Kunststoff oder Keramik gebildet.

In einer bevorzugten Ausführungsform ist der Festschmierstoff ausgewählt aus der Gruppe bestehend aus WS₂, MoS₂, NbS₂, NbSe₂, TaS₂, MoTe₂, MoSe₂, WTe₂, WSe₂, HfS₂, SnS₂, Bi₂S₃, Sb₂S₃ und/oder Mischungen hiervon.

In einer weiteren Ausführungsform, die nicht Teil der vorliegenden Erfindung ist, ist der Festschmierstoff ausgewählt aus der Gruppe bestehend aus Graphit, Graphitoxid, Graphitfluorid, Phthalocyanin, organischen Polymeren, insbesondere Polytetrafluorethylen (PTFE) und/oder hiervon abgeleiteten Metallkomplexen.

Die Gleitschicht des elektrischen Kontakts darf eine maximale Schichtdicke nicht überschreiten, da sich diese negativ auf den Kontaktwiderstand auswirken kann. Die Gleitschicht weist eine Schichtdicke von maximal 4 µm, bevorzugt eine Schichtdicke von maximal 3 µm, bevorzugter eine Schichtdicke von maximal 2 µm, noch mehr bevorzugt eine Schichtdicke von maximal 1 µm und am bevorzugtesten von 0,01 µm - 1 µm, auf. In einer ganz besonders vorteilhaften Ausführungsvariante beträgt die Schichtdicke der Gleitschicht von 10 nm bis 500 nm, bevorzugt von 50 nm bis 500 nm.

Weiterhin bevorzugt enthält der Festschmierstoff einen fein-dispersen Feststoffbestandteil mit einer mittleren Partikelgröße (d50) von 10 nm - 100 µm, bevorzugt mit einer mittleren Partikelgröße (d50) von 50 nm - 75 µm, bevorzugter mit einer mittleren Partikelgröße (d50) von 100 nm - 50 µm, noch bevorzugter mit einer mittleren Partikelgröße (d50) von 500 nm - 35 µm, und noch mehr bevorzugt mit einer mittleren Partikelgröße (d50) von 1 µm - 20 µm.

Grundsätzlich ist vorgesehen, dass die Gleitschicht das darunter angeordnete Substrat oder die darunter angeordnete Zwischenschicht vollständig bedeckt, um die erläuterten tribologischen Vorteile zu erzielen. Gemäß einer bevorzugten Ausführungsform bedeckt die Gleitschicht das darunter angeordnete Substrat oder die darunter angeordnete Zwischenschicht vollständig.

Allerdings ist es auch möglich, Gleitschichten herzustellen, die das darunter angeordnete Substrat oder die darunter angeordnete Zwischenschicht nur teilweise bedecken, um die Eigenschaften der Oberfläche hierdurch zu beeinflussen. Durch eine gezielte Steuerung der Aufbringungsparameter können unbeschichtete Bereiche gebildet und dennoch eine Verbesserung der tribologischen Eigenschaften erzielt werden. Hierdurch können beispielsweise die günstigen Eigenschaften einer Zwischenschicht, speziell deren niedriger Übergangswiderstand, erhalten bleiben. Gemäß einer bevorzugten Ausführungsform bedeckt die Gleitschicht das darunter angeordnete Substrat oder die darunter angeordnete Zwischenschicht zumindest teilweise. Vorzugsweise ist das Substrat oder die Zwischenschicht strukturiert; und/oder ist das Substrat oder die Zwischenschicht zumindest teilweise bedeckende Gleitschicht strukturiert.

Bevorzugt liegt der Reibkoeffizient des elektrischen Kontakts im Bereich von 0,02 - 0,90, bevorzugt von 0,10 - 0,87, und bevorzugter von 0,17 - 0,85.

Bevorzugt bleibt der Reibkoeffizient über 1000 Steckzyklen konstant.

Ebenso bevorzugt liegt der Kontaktwiderstand des elektrischen Kontakts im Bereich von 0,1 - 60 mOhm, bevorzugt von 0,6 - 50 mOhm, bevorzugter von 0,7 - 48,5 mOhm, noch bevorzugter von 0,8 - 40 mOhm und noch mehr bevorzugt von 0,8 - 35 mOhm.

Bevorzugt bleibt der Kontaktwiderstand über 1000 Steckzyklen konstant.

Der die Gleitschicht bildende Festschmierstoff ist ausgewählt aus der Gruppe bestehend aus Sulfiden, Seleniden, Telluriden.

In einer besonders vorteilhaften Ausführungsvariante ist der Festschmierstoff ausgewählt aus der Gruppe bestehend aus WS₂, MoS₂, NbS₂, NbSe₂, TaS₂, MoTe₂, MoSe₂, WTe₂, WSe₂, HfS₂, SnS₂, Bi₂S₃, Sb₂S₃ und/oder Mischungen hiervon. Besonders bevorzugt sind hierbei die Sulfide WS₂ und MoS₂, da sie eine hohe Affinität für Metalloberflächen aufweisen und demnach eine starke Bindung zu diesen ausbilden.

Insbesondere Wolframdisulfid weist ferner den Vorteil aus, dass die Partikel untereinander nahezu keine Wechselwirkung aufweisen, so dass bei der Verwendung von Wolframdisulfid als Festschmierstoff sehr dünne Gleitschichten auf der Zwischenschicht des elektrischen Kontakts erzeugt werden können.

In einer weiteren vorteilhaften Ausführungsvariante kann der Festschmierstoff ausgewählt sein aus der Gruppe bestehend aus Graphit, Graphitoxid, Graphitfluorid, Phthalocyanin, organischen Polymeren, insbesondere Polytetrafluorethylen (PTFE), und/oder hiervon abgeleiteten Metallkomplexen.

In einem weiteren Aspekt betrifft die vorliegende Erfindung die Verwendung eines erfinderischen elektrischen Kontaktes für Steckverbindungen.

Ein weiterer Aspekt betrifft die Verwendung eines Festschmierstoffs zur Einstellung eines Reibkoeffizienten von Oberflächen für elektrische Kontakte.

Der Festschmierstoff ist ausgewählt aus der Gruppe bestehend aus Sulfiden, Seleniden und/oder Telluriden; oder der Festschmierstoff ist ausgewählt aus der Gruppe bestehend aus WS₂, MoS₂, NbS₂, NbSe₂, TaS₂, MoTe₂, MoSe₂, WTe₂, WSe₂, HfS₂, SnS₂, Bi₂S₃, Sb₂S₃ und/oder Mischungen hiervon; oder der Festschmierstoff ist ausgewählt aus der Gruppe bestehend aus Graphit, Graphitoxid, Graphitfluorid, Phthalocyanin, organischen Polymeren, insbesondere Polytetrafluorethylen (PTFE) und/oder hiervon abgeleitete Metallkomplexen.

### Figurenbeschreibung

Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere ist darauf hinzuweisen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können.

Es zeigen:
- Fig. 1: eine erste Ausführungsvariante des erfindungsgemäßen elektrischen Kontakts mit einer Gleitschicht (6) auf einem Substrat (2);
- Fig. 2: eine zweite Ausführungsvariante des erfindungsgemäßen elektrischen Kontakts mit einer Zwischenschicht (5) auf einem Substrat (2) und einer darauf angeordneten Gleitschicht (6);
- Fig. 3: eine dritte Ausführungsvariante des erfindungsgemäßen elektrischen Kontakts mit einer ersten weiteren Metallschicht (3), einer Zwischenschicht (5) und einer Gleitschicht (6) auf einem Substrat (2);
- Fig. 4: eine vierte Ausführungsvariante des erfindungsgemäßen elektrischen Kontakts mit einer ersten weiteren Metallschicht (3), einer zweiten weiteren Metallschicht (4), einer Zwischenschicht (5) und einer Gleitschicht (6) auf einem Substrat (2);
- Fig. 5: Kontaktwiderstandsmessungen an beschichteten Messingblechen mit einer Silberschicht (Referenzbleche; VB1) und beschichteten Messingblechen mit einer Silberschicht und darauf aufgebrachter erfindungsgemäßer Gleitschicht (EB1);
- Fig. 6: Reibkoeffizientmessungen an beschichteten Messingblechen mit einer Silberschicht (Referenzbleche; VB1) und beschichteten Messingblechen mit einer Silberschicht und darauf aufgebrachter erfindungsgemäßer Gleitschicht (EB1);
- Fig. 7: Kontaktwiderstandsmessungen an beschichteten Messingblechen mit einer Zinnschicht (Referenzbleche, VB2) und beschichteten Messingblechen mit einer Zinnschicht und darauf aufgebrachter erfindungsgemäßer Gleitschicht (EB2 und EB3);
- Fig. 8: Reibkoeffizientmessungen an beschichteten Messingblechen mit einer Zinnschicht (Referenzbleche, VB2) und beschichteten Messingblechen mit einer Zinnschicht und darauf aufgebrachter erfindungsgemäßer Gleitschicht (EB2 und EB3).

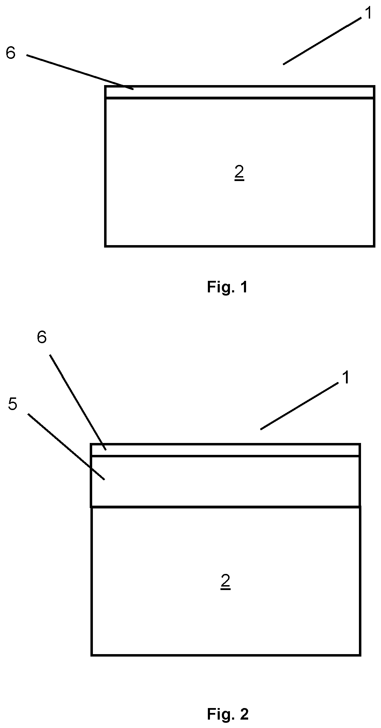

Figur 1 zeigt eine erste Ausführungsvariante des erfindungsgemäßen elektrischen Kontakts (1), der ein Substrat (2), welches vorliegend aus Messing (CuZn39Pb2) besteht, umfasst. Auf dieses Substrat (2) wurde eine Gleitschicht (6) aufgetragen. Zur Herstellung des elektrischen Kontakts (1) wurde die Gleitschicht (6) durch Aufreiben von Wolframdisulfidpartikeln mit einem Zellstofftuch auf die metallische Oberfläche des Substrats (2) aufgebracht.

Figur 2 zeigt eine zweite Ausführungsvariante des erfindungsgemäßen elektrischen Kontakts (1), der ein Substrat (2), welches vorliegend aus Messing (CuZn39Pb2) besteht, sowie eine Zwischenschicht (5) und eine Gleitschicht (6), die auf der Zwischenschicht (5) aufgetragen wurde, umfasst. Zur Herstellung des elektrischen Kontakts (1) wurde zunächst eine Schicht aus Reinsilber (5) mit einer Schichtdicke von 5 µm auf die metallische Oberfläche des Substrats (2) galvanotechnisch aufgetragen, so dass die Zwischenschicht (5) bestehend aus Silber entstand. Sodann wurde die Gleitschicht (6) durch Aufreiben von Wolframdisulfidpartikeln mit einem Zellstofftuch auf die Zwischenschicht (5) aufgebracht, die in Form einer Verfärbung der darunter angeordneten Silberschicht, welche die Zwischenschicht (5) darstellt, erkennbar war.

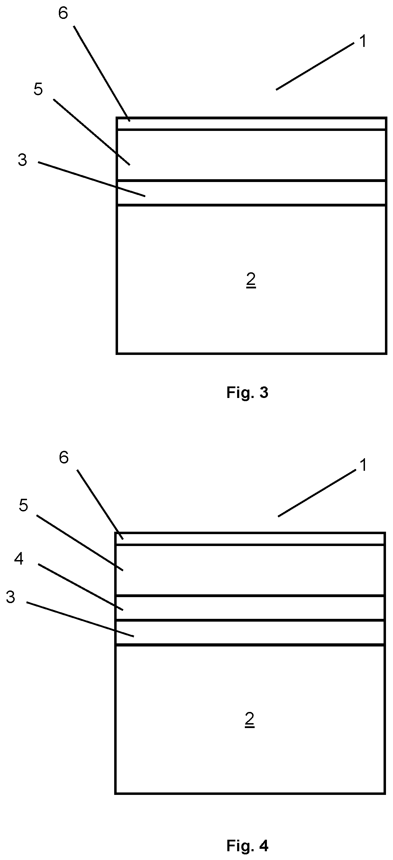

In Figur 3 ist eine dritte Ausführungsvariante des erfindungsgemäßen elektrischen Kontakts (1) gezeigt, die ein Substrat (2), welches vorliegend aus Messing (CuZn39Pb2) besteht, sowie eine erste weitere Metallschicht (3), eine Zwischenschicht (5) und eine Gleitschicht (6), die auf der Zwischenschicht (5) aufgetragen wurde, umfasst. Zur Herstellung des elektrischen Kontakts (1) wurde zunächst eine Schicht aus Kupfer, welche die erste weitere Metallschicht (3) darstellt, mit einer Schichtdicke von 2 µm auf dem Messing-Substrat (2) galvanotechnisch aufgetragen. Anschließend wurde eine Schicht aus Reinsilber (5) mit einer Schichtdicke von 5 µm auf die metallische Oberfläche des Substrats (2) galvanotechnisch aufgetragen, so dass die Zwischenschicht (5) bestehend aus Silber entstand. Sodann wurde die Gleitschicht (6) durch Aufreiben von Wolframdisulfidpartikeln mit einem Zellstofftuch auf die Zwischenschicht (5) aufgebracht, die in Form einer Verfärbung der darunter angeordneten Silberschicht, welche die Zwischenschicht (5) darstellt, erkennbar war.

In Figur 4 ist eine vierte Ausführungsvariante des erfindungsgemäßen elektrischen Kontakts (1) gezeigt, die ein Substrat (2), welches vorliegend aus Messing (CuZn39Pb2) besteht, sowie eine erste weitere Metallschicht (3), eine zweite weitere Metallschicht (4), eine Zwischenschicht (5) und eine Gleitschicht (6), die auf der Zwischenschicht (5) aufgetragen wurde, umfasst. Zur Herstellung des elektrischen Kontakts (1) wurde zunächst eine Schicht aus Kupfer, welche die erste weitere Metallschicht (3) darstellt, mit einer Schichtdicke von 2 µm auf dem Messing-Substrat (2) galvanotechnisch aufgetragen. Anschließend wurde eine Schicht aus Reinnickel, welche die zweite weitere Metallschicht (4) darstellt, mit einer Schichtdicke von 2 µm auf die Kupferschicht (3) und sodann eine Schicht aus Reinzinn, welche die Zwischenschicht (5) darstellte, mit einer Schichtdicke von 5 µm galvanotechnisch aufgetragen. Hiernach wurde die Gleitschicht (6) durch Aufreiben von Wolframdisulfidpartikeln mit einem Zellstofftuch auf die Zwischenschicht (5) aufgebracht, die in Form einer Verfärbung der darunter angeordneten Zinnschicht (5) erkennbar war.

### Bezugszeichenliste

- 1: elektrischer Kontakt
- 2: Substrat
- 3: erste weitere Metallschicht
- 4: zweite weitere Metallschicht
- 5: Zwischenschicht
- 6: Gleitschicht

### Beispiele

### Ausführungsbeispiel 1:

Für das Ausführungsbeispiel 1 wurden Messingbleche (Material: CuZn39Pb2) der Firma Metaq GmbH mit den Maßen 75 mm x 17 mm x 1 mm sowie Bronzekugeln (Material: CuSn6) von der Firma KUGELPOMPEL HSI-Solutions GmbH mit einem Durchmesser von 3 mm verwendet, die galvanotechnisch beschichtet wurden. Hierzu wurden die Messingbleche als auch die Bronzekugeln zunächst verkupfert und anschließend mit einer Reinsilberschicht überzogen. Zwischen jedem Schritt wurde gründlich mit Wasser gespült.

Die Galvanisierung der Messingbleche sowie der Bronzekugeln wurde gemäß den Verfahren, die in der DE 10 2018005 352 und DE 10 2018 005 348 beschrieben sind, durchgeführt.

Im Anschluss an die Galvanisierung wurde die Gleitschicht aufgetragen.

Ein Teil der beschichteten Messingbleche wurde als Referenz zurückgelegt, Vergleichsbeispiel 1 (VB1).

Der andere Teil wurde mit einer Gleitschicht beschichtet, erfinderisches Beispiel 1 (EB1).

Auftragen der Gleitschicht: Hierzu wurden Wolframdisulfidpartikel (WS₂, Hersteller Tribotecc GmbH, Wien) mit einer mittleren Partikelgröße von d50 = 3 µm und d90 = 8 µm mittels Aufreiben mit einem Zellstofftuch aufgebracht.

Die Bronzekugeln wurden analog als Trommelware zunächst mit einer 2 µm starken Kupferschicht und anschließend mit einer 5 µm starken Silberschicht beschichtet.

### Verschleißprüfung

Für die Verschleißprüfung wurden die beschichteten Messingbleche, EB1 und VB1, in einem Prüfstand zur Simulation von Steckzyklen eingebaut und mit den beschichteten Bronzekugeln gerieben. An die Kugel wurde eine Gewichtskraft von 1,0 N angelegt. Diese rieb mit der ausgewählten Kraft über eine Strecke von 3 mm bei einer Frequenz von 1 Hz über das beschichtete Messingblech. Dies wurde für 1000 Zyklen wiederholt. Während des Versuchs wurde die Reibkraft mit einer Kraftmessdose U9C (Firma HBM) gemessen. Zusätzlich wird nach jedem Zyklus der Kontaktwiderstand am Kontakt zwischen dem beschichteten Messingblech und der Kugel gemessen. Die Messung des Kontaktwiderstands erfolgt mittels Vier-Leiter-Methode mit einem Digitalmultimeter 2750/E (Firma Keithley).

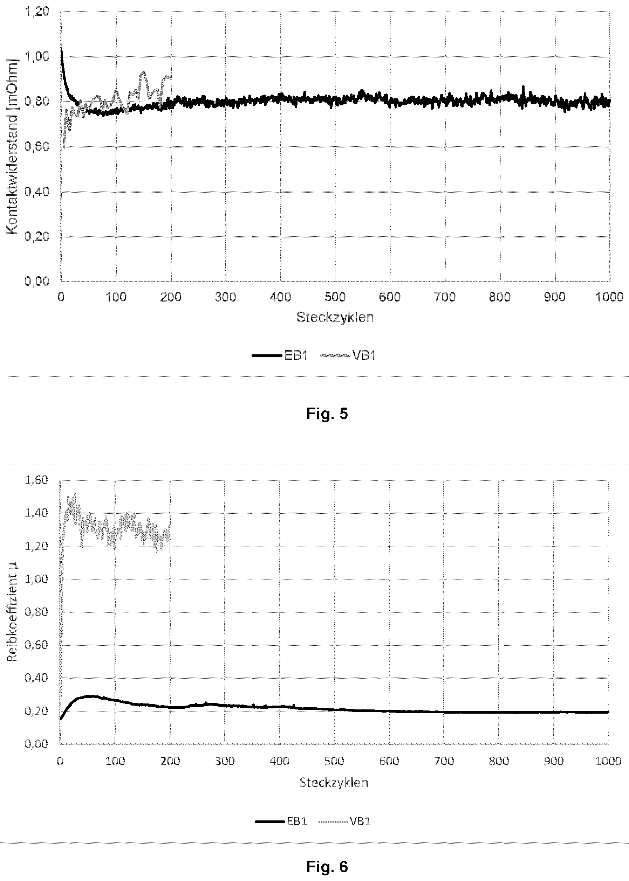

In Fig. 5 sind die Ergebnisse aus der Messung des Kontaktwiderstands gezeigt. Bei den erfindungsgemäß beschichteten Messingblechen, EB1, blieb der Kontaktwiderstand nach über 1000 Steckzyklen sehr stabil im Bereich von 0,8 mOhm, wohingegen die Referenzbleche, VB1, leicht höhere Kontaktwiderstandswerte zeigten. Ferner zeigte sich, dass der Verschleiß durch die Behandlung mit den Wolframdisulfidpartikeln signifikant reduziert werden konnte. Wie Fig. 5 zu entnehmen ist, konnte mit den erfindungsgemäß beschichteten Messingblechen (EB1) über 1000 Steckzyklen durchgeführt werden, wohingegen die unbehandelten Messingbleche (VB1) bereits nach 200 Steckzyklen einen starken Verschleiß zeigten, der sich in Form eines partiellen Durchriebs äußerte. Der Test wurde daher nach 200 Steckzyklen abgebrochen.

Des Weiteren konnte durch die Behandlung mit Wolframdisulfid eine deutliche Reduktion des Reibkoeffizienten erzielt werden (s. Fig. 6). Die Referenzbleche (VB1) zeigten einen Reibkoeffizienten von 1,2, wohingegen die erfindungsgemäß beschichteten Messingbleche (EB1) einen Reibkoeffizienten im Bereich von 0,2 - 0,3 zeigten. Ferner zeigte sich, dass der Reibkoeffizient über 1000 Steckzyklen konstant blieb.

### Ausführungsbeispiel 2:

Für das Ausführungsbeispiel 2 wurden Messingbleche (Material: CuZn39Pb2; F49 (hart)) der Firma Metaq GmbH mit den Maßen 75 mm x 17 mm x 1 mm sowie Bronzekugeln (Material: CuSn6) von der Firma KUGELPOMPEL HSI-Solutions GmbH mit einem Durchmesser von 3 mm verwendet, die galvanotechnisch beschichtet wurden. Hierzu wurden die Messingbleche als auch die Bronzekugeln zunächst verkupfert und anschließend mit einer Zwischenschicht aus Nickel und Zinn überzogen. Zwischen jedem Schritt wurde gründlich mit Wasser gespült.

Die Galvanisierung der Messingbleche sowie der Bronzekugeln umfasste die folgenden Schritte: Die Entfettung der Substrate, das Ätzen von Kupfer mit Bad von schwefelsaurer, komplexbildnerfreier Kupferaktivierung sowie die Behandlung mit Glanzkupferbad wurde gemäß den Verfahren, die in der DE 10 2018005 352 und DE 10 2018 005 348 beschrieben sind, durchgeführt.

Die Vernickelung wurde anschließend in einem Nickelbad mit einem Watts'schen Nickelelektrolyt (HSO Ni 110; Hersteller: HSO Herbert Schmidt GmbH & Co. KG, Solingen) nach bekannten Verfahren durchgeführt.

Danach wurde für die Zinnschicht aus einem Mattzinnelektrolyten (SLOTOTIN 40; Hersteller: Dr.-Ing. Max Schlötter GmbH & Co. KG, Geislingen), welcher Zinn(II)methansulfonat als Zinnsalz enthielt, nach bekannten Verfahren abgeschieden.

Ein Teil der beschichteten Messingbleche wurde als Referenz zurückgelegt, Vergleichsbeispiel 2 (VB2).

Der andere Teil wurde mit einer Gleitschicht beschichtet, erfinderisches Beispiel 2 (EB2) und erfinderisches Beispiel 3 (EB3).

Auftragen der Gleitschicht: Hierzu wurden Wolframdisulfidpartikel (WS₂, Hersteller Tribotecc GmbH, Wien) mit einer mittleren Partikelgröße von d50 = 3 µm und d90 = 8 µm mittels Aufreiben mit einem Zellstofftuch aufgebracht. In dem vorliegenden Ausführungsbeispiel wurden die Mengen an Wolframdisulfidpartikeln variiert, so dass zwei unterschiedliche Schichtdicken, EB2 und EB3, hergestellt und analysiert worden sind.

Die Bronzekugeln wurden analog als Trommelware zunächst mit einer 2 µm starken Kupferschicht, sodann mit einer 2 µm starken Nickelschicht und anschließend mit einer 5 µm starken Zinnschicht beschichtet.

### Verschleißprüfung

Für die Verschleißprüfung wurden die beschichteten Messingbleche, EB2, EB3 und VB2, in einem Prüfstand zur Simulation von Steckzyklen eingebaut und mit den beschichteten Bronzekugeln gerieben. An die Kugel wurde eine Gewichtskraft von 1,0 N angelegt. Diese rieb mit der ausgewählten Kraft über eine Strecke von 3 mm bei einer Frequenz von 1 Hz über das beschichtete Messingblech. Dies wurde für 50 Zyklen wiederholt. Während des Versuchs wurde die Reibkraft mit einer Kraftmessdose U9C (Firma HBM) gemessen. Zusätzlich wird nach jedem Zyklus der Kontaktwiderstand am Kontakt zwischen dem beschichteten Messingblech und der Kugel gemessen. Die Messung des Kontaktwiderstands erfolgt mittels Vier-Leiter-Methode mit einem Digitalmultimeter 2750/E (Firma Keithley).

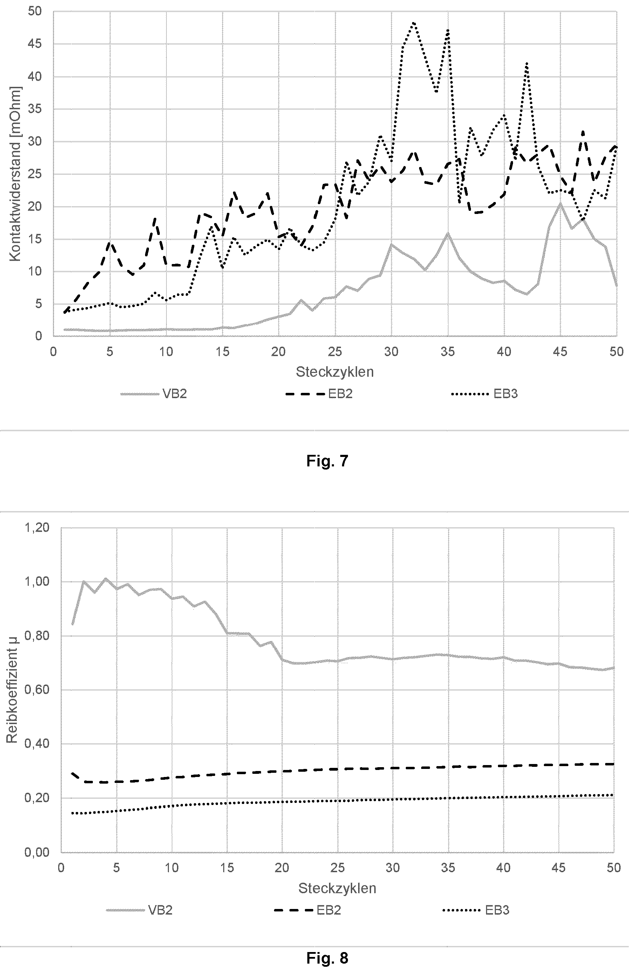

In Fig. 7 sind die Ergebnisse aus der Messung des Kontaktwiderstands gezeigt. Bei den erfindungsgemäß beschichteten Messingblechen stieg der Kontaktwiderstand bei den Proben mit einer höheren Wolframdisulfidmenge (EB3) nach über 50 Steckzyklen von 5 mOhm auf 50 mOhm. Bei den Proben mit einer geringeren Wolframdisulfidmenge (EB2) stieg der Kontaktwiderstand nach über 50 Steckzyklen von 5 mOhm auf 30 mOhm.

In der Fig. 8 sind die Ergebnisse aus den Messungen des Reibkoeffizienten zusammengefasst. In Abhängigkeit der Wolframdisulfidmenge wurde bei den Proben EB2 und EB3 ein Reibkoeffizient von 0,15 - 0,3 ermittelt. Bei der Probe ohne Gleitschicht (VB2) konnte ein Reibkoeffizient von 0,7 - 0,8 beobachtet werden.

### Oberflächenbestimmung EB1, EB2 und EB3 mit EDX-REM

Die chemische Zusammensetzung des oberflächennahen Bereichs wurde semiquantitativ mittels energiedispersiver Röntgenspektroskopie bestimmt. Dazu wurden mit einem X-Flash Detector 410-M (Bruker AXS Microanalysis GmbH), welches in einem Elektronenmikroskop JSM-6610 LV (Hersteller: JEOL) eingebaut ist, mit Anregungsspannungen von 10 kV sowie 20 kV Messungen an den Proben durchgeführt. Es wurde jeweils eine Fläche von etwa 1 mm² im Umfeld jener Bereiche, die zur Bestimmung des Kontaktwiderstandes und des Reibkoeffizienten verwendet wurden, analysiert. Jede Fläche wurde mit beiden Anregungsspannungseinstellungen analysiert. Die Auswertung der Messungen erfolgte mit dem Programm Esprit (Bruker).

Bei den Messungen handelt es sich um einzelne Messungen von Bereichen mit jeweils 1 mm² Fläche. Die Messungen erfolgten dabei im unmittelbaren Nahbereich der aus den Steckzyklenversuchen resultierenden Verschleißspuren.

**Tabelle 1**

| Beispiel | EB1 (Ag-WS2) | | EB2 (Sn-WS2) | | EB3 (Sn-WS2) | |
|---|---|---|---|---|---|---|
| Beschleunigungsspannung (kV) | 20 | 10 | 20 | 10 | 20 | 10 |
| Elektronenwechselwirkungstiefe der Analyse (berechnet) (µm) | 1,0 | 0,3 | 1,4 | 0,4 | 1,3 | 0,4 |
| Ag (Gew%) | 99,70 | 99,31 | - | - | - | - |
| Sn (Gew%) | - | - | 99,22 | 96,14 | 95,56 | 85,15 |
| W (Gew%) | 0,00 | 0,46 | 0,38 | 3,02 | 2,89 | 10,11 |
| S (Gew%) | 0,30 | 0,23 | 0,40 | 0,84 | 1,55 | 4,74 |

Wie aus Tabelle 1 hervorgeht, wurde durch die Variation der Beschleunigungsspannung des Elektronenstrahls die Elektronenwechselwirkungstiefe variiert. Bei den Analysen mit 10 kV Beschleunigungsspannung ist die Elektronenwechselwirkungstiefe geringer und die resultierenden Wolfram- bzw. Schwefelgehalte sind höher, da sich diese Elemente an der Oberfläche, d.h. in der Gleitschicht, befinden. Da sich die WS₂-Partikel nur auf der Oberfläche befinden, zeigen die EDX-Analysen bei geringerer Anregungsspannung höhere Festschmierstoffgehalte, da hier ausschließlich die obersten Bereiche analytisch erfasst werden. Im Gegensatz dazu wird bei den Analysen mit höherer Anregungsspannung und damit ausgedehnterer Wechselwirkungstiefe ein größerer Anteil der festschmierstoffpartikelfreien tieferen Abschnitte der Zwischenschichten miterfasst, wodurch der Festschmierstoffgehalt entsprechend niedriger ist. Die Messungen bestätigen, dass die Festschmierstoffe im oberflächennahen Bereich in höheren Konzentrationen vorhanden sind.

## Patentansprüche

1. Verfahren zur Herstellung eines elektrischen Steckkontakts (1), umfassend die Schritte
a) Bereitstellen eines Substrats, wobei das Substrat eine metallische und/oder metallisierte Oberfläche aufweist, und
b) Aufbringen einer Gleitschicht auf die metallische und/oder metallisierte Oberfläche des Substrats (2), wobei die Gleitschicht (6) eine Schichtdicke von 0,01 µm bis 4 µm aufweist,
wobei die Gleitschicht (6) durch mechanisches Einreiben, Aufpolieren und/oder Schwabbeln eines Festschmierstoffs aufgebracht wird; oder
wobei die Gleitschicht (6) durch Sputtern eines Festschmierstoffs aufgebracht wird; oder
wobei die Gleitschicht (6) durch Aufsprühen eines Festschmierstoffs unter Verwendung eines Trägergases, aufgebracht wird; oder
wobei die Gleitschicht (6) durch Aufbringen eines Festschmierstoffs mittels eines Trommelwäschers aufgebracht wird.

2. Verfahren nach Anspruch 1, wobei das Substrat (2) eine Zwischenschicht (5) aufweist, wobei die Zwischenschicht (5) bevorzugt galvanotechnisch, durch Eintauchen in eine metallische Schmelze, thermische Spritzverfahren, Verfahren zur physikalischen Gasphasenabscheidung, durch Feuerverzinnung oder Verfahren zur chemischen Gasphasenabscheidung aufgebracht wird, bevorzugter galvanotechnisch oder durch Feuerverzinnung auf das Substrat (2) aufgebracht wird, und wobei die Gleitschicht auf der Zwischenschicht (5) aufgebracht wird.

3. Verfahren nach Anspruch 2, wobei das Substrat (2) zumindest eine weitere Metallschicht (3) aufweist, wobei die zumindest eine weitere Metallschicht (3) zwischen dem Substrat (2) und der Zwischenschicht (5) angeordnet ist, wobei die zumindest eine weitere Metallschicht (3) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist; und/oder
wobei das Substrat (2) zumindest zwei weitere Metallschichten (3, 4) aufweist, wobei die zumindest zwei weiteren Metallschichten (3, 4) zwischen dem Substrat (2) und der Zwischenschicht (5) angeordnet sind, wobei die zumindest zwei weiteren Metallschichten (3, 4) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet sind; und/oder
wobei die Zwischenschicht (5) eine Zinn- oder Silberschicht ist.

4. Verfahren nach einem der vorhergehenden Ansprüche, wobei Schritt a) die folgenden Schritte umfasst:
- Bereitstellen eines Substrats (2) und Aufbringen einer Zwischenschicht (5); oder
- Bereitstellen eines Substrats (2), Aufbringen zumindest einer weiteren Metallschicht (3), vorzugsweise einer weiteren ersten Metallschicht (3) und einer weiteren zweiten Metallschicht (4), und anschließend Aufbringen einer Zwischenschicht (5); oder
- Bereitstellen eines Substrats (2), Aufbringen zumindest drei weitere Metallschichten und anschließend Aufbringen einer Zwischenschicht (5).

5. Elektrischer Kontakt, der nach dem Verfahren gemäß einem der Ansprüche 1 bis 4 erhältlich ist, aufweisend
ein Substrat (2), wobei das Substrat (2) eine metallische und/oder metallisierte Oberfläche aufweist, und
zumindest eine auf der metallischen und/oder metallisierten Oberfläche des Substrats (2) angeordnete Gleitschicht (6), die aus einem Festschmierstoff besteht,
wobei der elektrische Kontakt ein elektrischer Steckkontakt ist, und wobei die Gleitschicht (6) eine Schichtdicke von 0,01 µm bis 4 µm aufweist,
wobei der Festschmierstoff ausgewählt ist aus der Gruppe bestehend aus Sulfiden, Seleniden und/oder Telluriden.

6. Elektrischer Kontakt nach Anspruch 5,
wobei das Substrat (2) eine auf der metallischen und/oder metallisierten Oberfläche des Substrats (2) angeordnete Zwischenschicht (5) aufweist, wobei die Zwischenschicht vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, und wobei die Gleitschicht (6) auf der Zwischenschicht (5) angeordnet ist; oder
wobei das Substrat (2) eine auf der metallischen und/oder metallisierten Oberfläche des Substrats (2) angeordnete zumindest eine weitere Metallschicht (3) aufweist, wobei die zumindest eine weitere Metallschicht (3) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, und wobei auf der zumindest einen weiteren Metallschicht (3) eine Zwischenschicht (5) angeordnet ist, wobei die Zwischenschicht (5) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, wobei die Gleitschicht (6) auf der Zwischenschicht (5) angeordnet ist.

7. Elektrischer Kontakt nach Anspruch 5,
wobei das Substrat (2) eine auf der metallischen und/oder metallisierten Oberfläche des Substrats (2) angeordnete zumindest eine erste weitere Metallschicht (3) aufweist, wobei die zumindest eine erste weitere Metallschicht (3) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, wobei auf der ersten weiteren Metallschicht (3) eine zweite weitere Metallschicht (4) angeordnet ist, wobei die zumindest eine zweite weitere Metallschicht (4) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, und wobei auf der zumindest zweiten weiteren Metallschicht (4) eine Zwischenschicht (5) angeordnet ist, wobei die Zwischenschicht (5) vorzugsweise aus einem der Metalle ausgewählt aus der Gruppe umfassend Gold (Au), Kupfer (Cu), Nickel (Ni), Palladium (Pd), Platin (Pt), Rhodium (Rh), Ruthenium (Ru), Silber (Ag), Zink (Zn), Zinn (Sn) und/oder einer Legierung hiervon gebildet ist, und wobei die Gleitschicht (6) auf der Zwischenschicht (5) angeordnet ist.

8. Elektrischer Kontakt nach Ansprüchen 5 bis 7,
wobei das Substrat aus Kupfer, Eisen, Zink, Zinn, Aluminium und/oder einer Legierung hiervon gebildet ist; oder
wobei das Substrat aus Kunststoff oder Keramik besteht.

9. Elektrischer Kontakt nach einem der Ansprüche 5 bis 8,
wobei der Festschmierstoff ausgewählt ist aus der Gruppe bestehend aus WS₂, MoS₂, NbS₂, NbSe₂, TaS₂, MoTe₂, MoSe₂, WTe₂, WSe₂, HfS₂, SnS₂, Bi₂S₃, Sb₂S₃ und/oder Mischungen hiervon.

10. Elektrischer Kontakt nach einem der Ansprüche 5 bis 8,
wobei der Festschmierstoff ausgewählt ist aus der Gruppe bestehend aus Graphit, Graphitoxid, Graphitfluorid, Phthalocyanin, organischen Polymeren, insbesondere Polytetrafluorethylen (PTFE) und/oder hiervon abgeleitete Metallkomplexen.

11. Elektrischer Kontakt nach einem der Ansprüche 5 bis 10,
wobei die Gleitschicht (6) eine Schichtdicke von maximal 3 µm, bevorzugt eine Schichtdicke von maximal 2 µm, bevorzugter eine Schichtdicke von maximal 1 µm und am bevorzugtesten von 0,1 µm - 1 µm aufweist; und/oder
wobei der Festschmierstoff einen fein-dispersen Feststoffbestandteil mit einer mittleren Partikelgröße (d50) von 10 nm - 100 µm, bevorzugt mit einer mittleren Partikelgröße (d50) von 50 nm - 75 µm, bevorzugter mit einer mittleren Partikelgröße (d50) von 100 nm - 50 µm, noch bevorzugter mit einer mittleren Partikelgröße (d50) von 500 nm - 35 µm, und noch mehr bevorzugt mit einer mittleren Partikelgröße (d50) von 1 µm - 20 µm, enthält.

12. Elektrischer Kontakt nach einem der vorhergehenden Ansprüche 5 bis 11,
wobei die Gleitschicht (6) das darunter angeordnete Substrat oder die darunter angeordnete Zwischenschicht (5) vollständig bedeckt; oder
wobei die Gleitschicht (6) das darunter angeordnete Substrat oder die darunter angeordnete Zwischenschicht (5) zumindest teilweise bedeckt.

13. Elektrischer Kontakt nach Anspruch 12,
wobei das Substrat oder die Zwischenschicht (5) strukturiert ist; und/oder
wobei die das Substrat oder die Zwischenschicht (5) zumindest teilweise bedeckende Gleitschicht (6) strukturiert ist.

14. Elektrischer Kontakt nach einem der Ansprüche 5 bis 13,
wobei der Kontaktwiderstand des elektrischen Kontakts im Bereich von 0,1 - 60 mOhm, bevorzugt 0,6 - 50 mOhm, und bevorzugter 0,7 - 48,5 mOhm liegt;
und/oder wobei der Kontaktwiderstand über 1000 Steckzyklen konstant bleibt.

15. Verwendung eines elektrischen Kontaktes nach einem der vorhergehenden Ansprüche 5 bis 14 für Steckverbindungen.

## Claims

1. A method for production of an electrical plug contact (1), comprising the following steps
a) providing a substrate, wherein the substrate has a metallic and/or metallized surface, and
b) applying a sliding layer to the metallic and/or metallized surface of the substrate (2), wherein the sliding layer (6) has a layer thickness of 0.01 µm to 4 µm,
wherein the sliding layer (6) is applied by mechanical rubbing, polishing, and/or buffing of a solid lubricant; or
wherein the sliding layer (6) is applied by sputtering a solid lubricant; or
wherein the sliding layer (6) is applied by spraying on a solid lubricant using a carrier gas; or
wherein the sliding layer (6) is applied by applying a solid lubricant by means of a drum washer.

2. The method according to claim 1, wherein the substrate (2) comprises an intermediate layer (5), wherein the intermediate layer (5) is preferably applied to the substrate (2) by electroplating, by immersion in a metallic melt, by thermal spraying methods, by methods of physical vapor deposition, by hot-dipping, or by methods of chemical vapor deposition, more preferably by electroplating or by hot-dipping, and wherein the sliding layer is applied to the intermediate layer (5).

3. The method according to claim 2, wherein the substrate (2) comprises at least one further metal layer (3), wherein the at least one further metal layer (3) is arranged between the substrate (2) and the intermediate layer (5), wherein the at least one further metal layer (3) is preferably formed from one of the metals selected from the group comprising gold (Au), copper (Cu), nickel (Ni), palladium (Pd), platinum (Pt), rhodium (Rh), ruthenium (Ru), silver (Ag), zinc (Zn), tin (Sn), and/or an alloy thereof; and/or
wherein the substrate (2) comprises at least two further metal layers (3, 4), wherein the at least two further metal layers (3, 4) are arranged between the substrate (2) and the intermediate layer (5), wherein the at least two further metal layers (3, 4) are preferably formed from one of the metals selected from the group comprising gold (Au), copper (Cu), nickel (Ni), palladium (Pd), platinum (Pt), rhodium (Rh), ruthenium (Ru), silver (Ag), zinc (Zn), tin (Sn), and/or an alloy thereof; and/or
wherein the intermediate layer (5) is a tin or silver layer.

4. The method according to any one of the preceding claims, wherein step a) comprises the following steps:
- providing a substrate (2) and applying an intermediate layer (5); or
- providing a substrate (2), applying at least one further metal layer (3), preferably a further first metal layer (3) and a further second metal layer (4), and then applying an intermediate layer (5); or
- providing a substrate (2), applying at least three further metal layers, and then applying an intermediate layer (5).

5. An electrical contact obtainable by way of the method according to any one of claims 1 to 4, having
a substrate (2), wherein the substrate (2) has a metallic and/or metallized surface, and
at least one sliding layer (6) which is arranged on the metallic and/or metallized surface of the substrate (2) and consists of a solid lubricant,
wherein the electrical contact is an electrical plug-in contact, and wherein the sliding layer (6) a layer thickness of 0.01 µm to 4 µm,
wherein the solid lubricant is selected from the group consisting of sulfides, selenides, and/or tellurides.

6. The electrical contact according to claim 5,
wherein the substrate (2) comprises an intermediate layer (5) arranged on the metallic and/or metallized surface of the substrate (2), wherein the intermediate layer is preferably formed from one of the metals selected from the group comprising gold (Au), copper (Cu), nickel (Ni), palladium (Pd), platinum (Pt), rhodium (Rh), ruthenium (Ru), silver (Ag), zinc (Zn), tin (Sn), and/or an alloy thereof, and wherein the sliding layer (6) is arranged on the intermediate layer (5); or
wherein the substrate (2) comprises at least one further metal layer (3) arranged on the metallic and/or metallized surface of the substrate (2), wherein the at least one further metal layer (3) is preferably formed from one of the metals selected from the group comprising gold (Au), copper (Cu), nickel (Ni), palladium (Pd), platinum (Pt), rhodium (Rh), ruthenium (Ru), silver (Ag), zinc (Zn), tin (Sn), and/or an alloy thereof, and wherein an intermediate layer (5) is arranged on the at least one further metal layer (3), wherein the intermediate layer (5) is preferably formed from one of the metals selected from the group comprising gold (Au), copper (Cu), nickel (Ni), nickel (Ni), palladium (Pd), platinum (Pt), rhodium (Rh), ruthenium (Ru), silver (Ag), zinc (Zn), tin (Sn), and/or an alloy thereof, wherein the sliding layer (6) is arranged on the intermediate layer (5).

7. The electrical contact according to claim 5,
wherein the substrate (2) comprises at least one first further metal layer (3) arranged on the metallic and/or metallized surface of the substrate (2), wherein the at least one first further metal layer (3) is preferably formed from one of the metals selected from the group comprising gold (Au), copper (Cu), nickel (Ni), palladium (Pd), platinum (Pt), rhodium (Rh), ruthenium (Ru), silver (Ag), zinc (Zn), tin (Sn), and/or an alloy thereof, wherein a second further metal layer (4) is arranged on the at least one further metal layer (3), wherein the at least one second further metal layer (4) is preferably formed from one of the metals selected from the group comprising gold (Au), copper (Cu), nickel (Ni), nickel (Ni), palladium (Pd), platinum (Pt), rhodium (Rh), ruthenium (Ru), silver (Ag), zinc (Zn), tin (Sn), and/or an alloy thereof, and wherein an intermediate layer (5) is arranged on the at least second further metal layer (4), wherein the intermediate layer (5) is preferably formed from one of the metals selected from the group comprising gold (Au), copper (Cu), nickel (Ni), nickel (Ni), palladium (Pd), platinum (Pt), rhodium (Rh), ruthenium (Ru), silver (Ag), zinc (Zn), tin (Sn), and/or an alloy thereof, wherein the sliding layer (6) is arranged on the intermediate layer (5).

8. The electrical contact according to claims 5 to 7,
wherein the substrate is formed of copper, iron, zinc, tin, aluminum, and/or an alloy thereof; or
wherein the substrate consists of plastic or ceramic.

9. The electrical contact according to any one of claims 5 to 8,
wherein the solid lubricant is selected from the group consisting of WS₂, MoS₂, NbS₂, NbSe₂, TaS₂, MoTe₂, MoSe₂, WTe₂, WSe₂, HfS₂, SnS₂, Bi₂S₃, Sb₂S₃, and/or mixtures thereof.

10. The electrical contact according to any one of claims 5 to 8,
wherein the solid lubricant is selected from the group consisting of graphite, graphite oxide, graphite fluoride, phthalocyanine, organic polymers, in particular polytetrafluoroethylene (PTFE), and/or metal complexes derived therefrom.

11. The electrical contact according to any one of claims 5 to 10,
wherein the sliding layer (6) has a layer thickness of at most 3 µm, preferably a layer thickness of at most 2 µm, more preferably a layer thickness of at most 1 µm, and most preferably of 0.1 µm - 1 µm; and/or
wherein the solid lubricant contains a finely dispersed solid component having a mean particle size (d50) of 10 nm - 100 µm, preferably having a mean particle size (d50) of 50 nm - 75 µm, more preferably having a mean particle size (d50) of 100 nm - 50 µm, even more preferably having a mean particle size (d50) of 500 nm - 35 µm, and even more preferably having a mean particle size (d50) of 1 µm - 20 µm.

12. The electrical contact according to any one of preceding claims 5 to 11,
wherein the sliding layer (6) completely covers the substrate or the intermediate layer (5) arranged underneath; or
wherein the sliding layer (6) at least partially covers the substrate arranged underneath or the intermediate layer (5) arranged underneath.

13. The electrical contact according to claim 12,
wherein the substrate or the intermediate layer (5) is structured; and/or
wherein the sliding layer (6) at least partially covering the substrate or the intermediate layer (5) is structured.

14. The electrical contact according to any one of claims 5 to 13,
where the contact resistance of the electrical contact is in the range of 0.1 - 60 mOhm, preferably 0.6 - 50 mOhm, and more preferably 0.7 - 48.5 mOhm;
and/or wherein the contact resistance remains constant over 1000 plug-in cycles.

15. Use of an electrical contact according to any one of preceding claims 5 to 14 for plug connections.

## Revendications

1. Procédé de fabrication d'un contact électrique enfichable (1), comprenant les étapes
a) de fourniture d'un substrat, dans lequel le substrat présente une surface métallique et/ou métallisée, et
b) d'application d'une couche de glissement sur la surface métallique et/ou métallisée du substrat (2), dans lequel la couche de glissement (6) présente une épaisseur de 0,01 µm à 4 µm,
dans lequel la couche de glissement (6) est appliquée par frottement mécanique, polissage et/ou flottement d'un lubrifiant solide ; ou
dans lequel la couche de glissement (6) est appliquée par pulvérisation d'un lubrifiant solide ; ou
dans lequel la couche de glissement (6) est appliquée par pulvérisation d'un lubrifiant solide avec utilisation d'un gaz porteur ; ou
dans lequel la couche de glissement (6) est appliquée par application d'un lubrifiant solide au moyen d'un laveur à tambour.

2. Procédé selon la revendication 1, dans lequel le substrat (2) présente une couche intermédiaire (5), dans lequel la couche intermédiaire (5) est appliquée de préférence par galvanotechnique, par immersion dans une masse métallique fondue, par des procédés de pulvérisation thermique, par des procédés de dépôt physique en phase vapeur, par étamage à chaud ou par des procédés de dépôt chimique en phase vapeur, de manière davantage préférée par galvanotechnique ou par étamage à chaud sur le substrat (2), et dans lequel la couche de glissement est appliquée sur la couche intermédiaire (5).

3. Procédé selon la revendication 2, dans lequel ledit substrat (2) présente au moins une autre couche métallique (3), dans lequel l'au moins une autre couche métallique (3) est disposée entre ledit substrat (2) et ladite couche intermédiaire (5), dans lequel l'au moins une autre couche métallique (3) est de préférence formée de l'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci ; et/ou
dans lequel le substrat (2) présente au moins deux autres couches métalliques (3, 4), dans lequel les au moins deux autres couches métalliques (3, 4) sont disposées entre le substrat (2) et la couche intermédiaire (5), dans lequel les au moins deux autres couches métalliques (3, 4) sont de préférence formées à partir de l'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci ; et/ou
dans lequel la couche intermédiaire (5) est une couche d'étain ou d'argent.

4. Procédé selon l'une quelconque des revendications précédentes, dans lequel l'étape a) comprend les étapes suivantes :
la fourniture d'un substrat (2) et l'application d'une couche intermédiaire (5) ; ou
la fourniture d'un substrat (2), l'application d'au moins une autre couche métallique (3), de préférence d'une autre première couche métallique (3) et d'une autre seconde couche métallique (4), puis l'application d'une couche intermédiaire (5) ; ou
la mise à disposition d'un substrat (2), l'application d'au moins trois autres couches métalliques, puis l'application d'une couche intermédiaire (5).

5. Contact électrique pouvant être obtenu par le procédé selon l'une des revendications 1 à 4, comprenant
un substrat (2), dans lequel le substrat (2) présente une surface métallique et/ou métallisée, et
au moins une couche de glissement (6) disposée sur la surface métallique et/ou métallisée du substrat (2) et constituée d'un lubrifiant solide,
dans lequel le contact électrique est un contact électrique enfichable et la couche de glissement (6) présente une épaisseur de 0,01 µm à 4 µm,
dans lequel le lubrifiant solide est choisi dans le groupe constitué des sulfures, des séléniures et/ou des tellures.

6. Contact électrique selon la revendication 5,
dans lequel le substrat (2) présente une couche intermédiaire (5) disposée sur la surface métallique et/ou métallisée du substrat (2), dans lequel la couche intermédiaire est de préférence formée d'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, et dans lequel la couche de glissement (6) est disposée sur la couche intermédiaire (5) ; ou
dans lequel le substrat (2) présente au moins une autre couche métallique (3) disposée sur la surface métallique et/ou métallisée du substrat (2), dans lequel l'au moins une autre couche métallique (3) est de préférence formée d'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, et dans lequel une couche intermédiaire (5) est disposée sur l'au moins une autre couche métallique (3), dans lequel la couche intermédiaire (5) est de préférence formée d'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, dans lequel la couche de glissement (6) est disposée sur la couche intermédiaire (5).

7. Contact électrique selon la revendication 5,
dans lequel le substrat (2) présente au moins une première autre couche métallique (3) disposée sur la surface métallique et/ou métallisée du substrat (2), dans lequel l'au moins une première autre couche métallique (3) est de préférence formée d'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, dans lequel un second autre métal (4) est disposé sur le premier métal supplémentaire (3), dans lequel l'au moins une seconde autre couche métallique (4) est formée de préférence de l'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, et dans lequel une couche intermédiaire (5) est disposée sur ladite au moins seconde autre couche métallique (4), dans lequel la couche intermédiaire (5) est de préférence constituée de l'un des métaux choisis dans le groupe comprenant l'or (Au), le cuivre (Cu), le nickel (Ni), le palladium (Pd), le platine (Pt), le rhodium (Rh), le ruthénium (Ru), l'argent (Ag), le zinc (Zn), l'étain (Sn) et/ou un alliage de ceux-ci, et dans lequel la couche de glissement (6) est disposée sur la couche intermédiaire (5).

8. Contact électrique selon les revendications 5 à 7,
dans lequel le substrat est constitué de cuivre, de fer, de zinc, d'étain, d'aluminium et/ou d'un alliage de ceux-ci ; ou dans lequel le substrat est en plastique ou en céramique.

9. Contact électrique selon l'une quelconque des revendications 5 à 8,
dans lequel le lubrifiant solide est choisi dans le groupe constitué de WS₂, de MoS₂, de NbS₂, de NbSe₂, de TaS₂, de MoTe₂, de MoSe₂, de WTe₂, de WSe₂, de HfS₂, de SnS₂, de Bi₂S₃, de Sb₂S₃ et/ou de mélanges de ceux-ci.

10. Contact électrique selon les revendications 5 à 8,
dans lequel le lubrifiant solide est choisi dans le groupe constitué du graphite, de l'oxyde de graphite, du fluorure de graphite, de la phtalocyanine, des polymères organiques, en particulier du polytétrafluoroéthylène (PTFE) et/ou des complexes métalliques dérivés de ceux-ci.

11. Contact électrique selon l'une des revendications 5 à 10, dans lequel la couche de glissement (6) présente une épaisseur de couche maximale de 3 µm, de préférence une épaisseur de couche maximale de 2 µm, de manière davantage préférée une épaisseur de couche maximale de 1 µm et de manière préférée entre toutes de 0,1 µm à 1 µm ; et/ou
dans lequel le lubrifiant solide contient un composant solide finement dispersé ayant une taille de particule moyenne (d50) de 10 nm à 100 µm, de préférence une taille de particule moyenne (d50) de 50 nm à 75 µm, de manière davantage préférée une taille de particule moyenne (d50) de 100 nm à 50 µm, de manière davantage préférée encore une taille de particule moyenne (d50) de 500 nm à 35 µm, et de manière davantage préférée encore une taille de particule moyenne (d50) de 1 µm à 20 µm.

12. Contact électrique selon l'une quelconque des revendications précédentes 5 à 11,
dans lequel la couche de glissement (6) recouvre complètement le substrat situé en dessous ou la couche intermédiaire (5) située en dessous ; ou
dans lequel la couche de glissement (6) recouvre au moins partiellement le substrat situé en dessous ou la couche intermédiaire (5) située en dessous.

13. Contact électrique selon la revendication 12,
dans lequel le substrat ou la couche intermédiaire (5) est structuré ; et/ou
dans lequel la couche de glissement (6) recouvrant au moins partiellement le substrat ou la couche intermédiaire (5) est structurée.

14. Contact électrique selon les revendications 5 à 13,
dans lequel la résistance de contact du contact électrique est comprise entre 0,1 et 60 mOhm, de préférence entre 0,6 et 50 mOhm, et de manière davantage préférée entre 0,7 et 48,5 mOhm ;
et/ou dans lequel la résistance de contact reste constante sur 1000 cycles de connexion.

15. Utilisation d'un contact électrique selon l'une quelconque des revendications précédentes 5 à 14 pour des connecteurs.
